Europäisches Patentamt

**European Patent Office**

Office européen des brevets

(11) Veröffentlichungsnummer: **0 106 254**
**A2**

(12) **EUROPÄISCHE PATENTANMELDUNG**

(21) Anmeldenummer: **83109863.7**

(22) Anmeldetag: **03.10.83**

(51) Int. Cl.³: **H 01 L 29/10**
**H 01 L 29/72**

(30) Priorität: **08.10.82 DE 3237379**

(43) Veröffentlichungstag der Anmeldung:
**25.04.84 Patentblatt 84/17**

(84) Benannte Vertragsstaaten:
**DE FR GB IT**

(71) Anmelder: **SIEMENS AKTIENGESELLSCHAFT**
**Berlin und München Wittelsbacherplatz 2**
**D-8000 München 2(DE)**

(72) Erfinder: **Mader, Hermann, Dr.**
**Carl-Duisberg-Strasse 42**
**D-8025 Unterhaching(DE)**

(54) **Transistor mit einstellbarer Energiebarriere und seine Verwendung.**

(57) Die Erfindung betrifft einen Transistor mit einstellbarer Energiebarriere und mit ohmschen Kontakten, der eine $n^+$ pn- oder $p^+$ np-Dreischichtstruktur (1, 2, 3) mit so dünn ausgebildeter mittlerer Schicht (2) (Basis) aufweist, daß bereits ohne äußbere, an die Elektroden angelegte elektrische Spannung bei der gegebenen Dotierung dieser Schicht (2) ihr gesamter Bereich an freien Ladungsträgern verarmt ist. Für die Dotierungsdichten N von Emitter (E)-, Basis (B)- und Kollektorzone (C) gilt: $N_E > N_B > N_C$. Die Steuerung des Kollektorstromes erfolgt über die Änderung einer Energiebarriere für Majoritätsträger mit einer angelegten Basis-Emitter-Spannung im Gegensatz zum Bipolartransistor, bei dem die Kollektorstromsteuerung durch Änderung der Minoritätsträgerdichte in der Basis mit einer angelegten Basis-Emitter-Spannung erfolgt. Der Anwendungsbereich erstreckt sich auf diskrete bipolare Halbleiterbauelemente und auf integrierte Schaltungen; Verwendung als Verstärker, Schalter, Mischer, Oszillator und Temperatursensor.

FIG 3

0106254

SIEMENS AKTIENGESELLSCHAFT             Unser Zeichen
Berlin und München                    VPA  82 P 1 9 4 2  E

Transistor mit einstellbarer Energiebarriere und seine
Verwendung.

Die vorliegende Patentanmeldung betrifft einen Transistor
mit einstellbarer Energiebarriere und mit ohmschen Kontakten, bestehend aus einer $n^+$ pn- oder $p^+$ np Dreischichtstruktur, bei der die mittlere Schicht (Basis) in ihrer
Dicke so dünn ausgebildet ist, daß bereits ohne äußere,
an die Elektroden angelegte elektrische Spannung bei der
gegebenen Dotierung dieser Schicht ihr gesamter Bereich
von freien Ladungsträgern verarmt ist, so wie seine Verwendung.

Beim Transistor erfolgt die Steuerung des Kollektorstromes durch Veränderung des Gradienten der Minoritätsträger in der neutralen Basis. Dieser Steuermechanismus
weist folgende Nachteile auf:

a) Die in die neutrale Basis injizierten Minoritätsträger
   verursachen eine sogenannten Basisdiffusionskapazität,
   die die Grenzfrequenz des Transistors verringert.

b) Die Änderung der Weite der Raumladungszonen in der
   Basis führen zur sogenannten Basisweitenmodulation,
   das heißt, zu einer nachteiligen Rückwirkung von Ausgangsspannung und -strom auf den Eingang des Transistors.

c) Der Überschuß der Minoritätsträger in der Basis hat
   einen relativ großen Rekombinationsstrom zur Folge,
   der als Steuerstrom zugeführt werden muß.

Edt 1 Plr/1.9.1982

Aufgabe der Erfindung ist es, einen Transistor als diskretes Halbleiterbauelement oder auch in integrierten Schaltungen zu schaffen, der die eben genannten Nachteile nicht aufweist.

Aus der DE-OS 28 05 097 ist ein Transistor mit einer Dreischichtstruktur bekannt, bei dem die mittlere Schicht so dünn ist, daß ihr gesamter Bereich zwischen den benachbarten Schichten bereits ohne angelegte elektrische Spannung von freien Ladungsträgern verarmt ist. Die mit diesem Transistor erzielten Vorteile bestehen darin, daß die Steuer- und Betriebsspannungen klein sind und damit auch die Verlustleistungen. Außerdem treten wegen dominierender Majoritätsträgereffekte kurze Schaltzeiten auf.

Die Erfindung betrifft eine Weiterbildung des bekannten Transistors und macht sich dabei die aus der europäischen Patentschrift 0 003 130 bekannten elektrischen Eigenschaften einer Halbleiterdiode mit Dreischichtstruktur und mit ohmschen Kontakten zunutze, bei der zur Verringerung der Energiebarriere die in der Dreischichtstruktur mittlere Schicht in ihrer Dicke so dünn gewählt ist, daß bereits ohne äußere, an die Elektroden angelegte elektrische Spannung bei der gegebenen Dotierung dieser Schicht der gesamte Bereich dieser Schicht von freien Ladungsträgern verarmt ist.

Die Erfindung ist dadurch gekennzeichnet, daß bei einem Transistor der eingangs genannten Art für die Dotierungsdichten N von Emitter (E)-, Basis (B)- und Kollektorzone (C) gilt: $N_E > N_B > N_C$. Die Höhe der Barriere wird durch die Dotierungsdichte und die Schichtdicke beeinflußt. Da der Strom exponentiell von der Barrierenhöhe abhängt, kann damit die Strom-Spannungskennlinie technologisch eingestellt werden. Außerdem ist die Erfindung dadurch gekennzeichnet, daß die Steuerung des Kollektorstroms über eine angelegte Basis-Emitter-Spannung ($U_{BE}$) erfolgt.

Es liegt im Rahmen der Erfindung, daß die Dotierungsdichte $N_E$ im Bereich von $10^{17} - 10^{21}$ cm$^{-3}$, $N_B$ im Bereich von $10^{15} - 10^{20}$ cm$^{-3}$ und $N_C$ im Bereich von $< 10^{18}$ cm$^{-3}$ liegt. Die Dicke der Basisschicht wird dabei auf $< 1000$ nm eingestellt.

Gemäß einem besonders günstigen Ausführungsbeispiel wird der Bereich der Schichtdicke der mittleren Schicht auf 50 nm bis 200 nm eingestellt.

Weitere Ausgestaltungen und auf der Erfindung beruhende weitere vorteilhafte Anwendungen der Erfindung gehen aus den Unteransprüchen hervor.

Die mit der Erfindung erzielten Vorteile bestehen darin, daß der Transistor, da der Kollektorstrom durch eine zwischen Basis und Emitter angelegte Spannung beeinflußt werden kann, sowohl als Verstärkerelement, als auch als Mischer oder Schalter und auch als Oszillator eingesetzt werden kann. Weitere Anwendungsmöglichkeiten ergeben sich als Temperatursensor, als Fotodetektor für sichtbare und/oder ultraviolette und/oder infrarote elektromagnetische Strahlung.

Für die Herstellung der Basis- und Emitterzone dieser Transistoren eignen sich die an sich bekannten Verfahren der Ionenimplantation, Molekularstrahlepitaxie, Diffusion, sowie die Dotierung durch Atomumwandlung infolge von Neutroneneinstrahlung.

Die Erfindung wird nun anhand der in der Zeichnung dargestellten Figuren näher erläutert und beschrieben. Es zeigen

Figur 1 schematisch den Aufbau und Raumladungsverlauf eines Transistors herkömmlicher Art,

Figur 2 schematisch den Aufbau und Raumladungsverlauf eines Transistors nach der Erfindung,

Figur 3 für einen Transistor nach der Erfindung den Bereich der Raumladungszone, den Verlauf der Raumladungsdichte $\varrho$ und den Verlauf der Energien $E_C$ und $E_V$ der Leitungs- und Valenzbandkanten bei thermischem Gleichgewicht,

Figur 4 für die in Figur 3 dargestellte Ausführungsform den Bereich der Raumladungszone, den Verlauf der Raumladungsdichte $\varrho$ und den Verlauf der Energien $E_C$ und $E_V$ der Leitungs- und Valenzbandkanten bei angelegter Kollektor-Emitter-Spannung $U_{CE}$,

Figur 5 für die in Figur 3 dargestellte Ausführungsform den Bereich der Raumladungszone, den Verlauf der Raumladungsdichte $\varrho$ und den Verlauf der Energien $E_C$ und $E_V$ der Leitungs- und Valenzbandkanten bei angelegter Kollektor-Emitterspannung $U_{CE}$ und Basis-Emitter-Spannung $U_{BE}$,

Figur 6 das Ausgangskennlinienfeld des erfindungsgemäßen Transistors mit $I_C$ als Kollektorstrom, $U_{CE}$ als Kollektor-Emitterspannung und $U_{BE}$ als Basis-Emittersteuerspannung;

die Figuren 7 bis 9 Transistoren nach der Lehre der Erfindung in Einzelbauweise,

die Figuren 10 bis 13 Transistoren nach der Lehre der Erfindung für den Einsatz in integrierten Schaltungen und

die Figuren 14 und 15 Transistoren nach der Lehre der Erfindung für den Einsatz als Fototransistoren, wobei das Licht entweder in den neutralen Bereich der Basiszone (Figur 14) oder in die
Emitterzone (Figur 15) eingestrahlt wird.

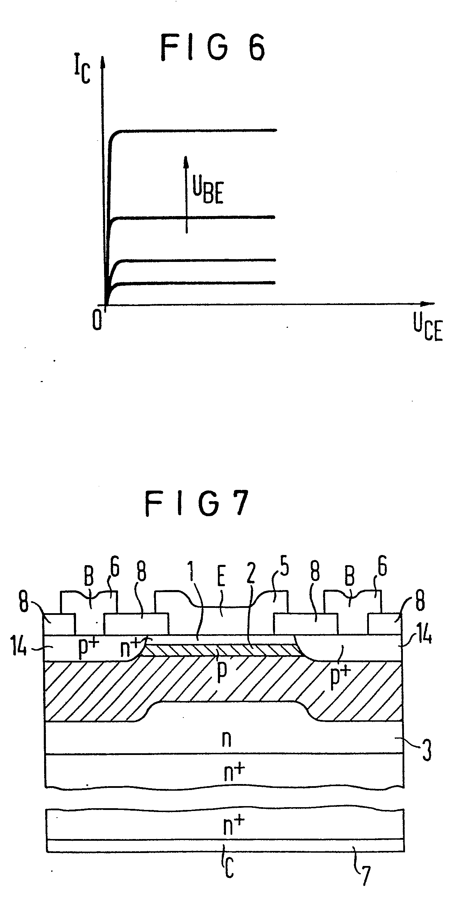

In den Figuren 7 bis 15 markieren die schraffierten Bereiche die Raumladungszonen bei thermischem
Gleichgewicht, das heißt ohne äußere angelegte
Spannung.

Für gleiche Teile gelten in allen Figuren gleiche Bezugszeichen.

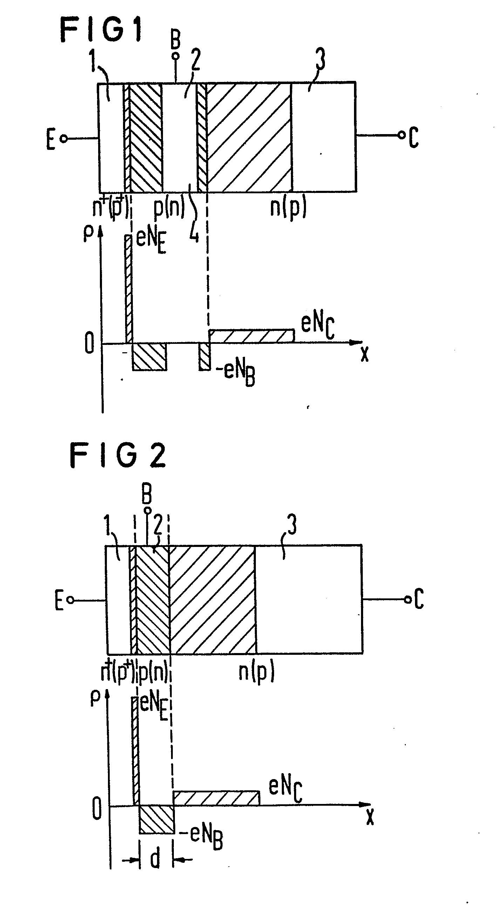

In Figur 1 ist der Aufbau und Raumladungsverlauf des bekannten Transistors schematisch dargestellt. Die Elektroden an den drei Schichten 1, 2, 3 ($n^+$ pn oder $p^+$ np) werden als Emitter (E), Basis (B) und Kollektor (C) bezeichnet. In der Basis 2 befindet sich zwischen der emitterseitigen (1) und der kollektorseitigen (2) Raumladungszone
ein neutraler Bereich 4. Die Dotierungsdichten sind $N_E$ im
Emitter, $N_B$ in der Basis und $N_C$ im Kollektor. Entsprechend
sind die Raumladungsdichten $\rho$ im Emitter $eN_E$, in der
Basis $-eN_B$ und im Kollektor $eN_C$.

In Figur 2 ist der Aufbau und Raumladungsverlauf des
Transistors mit einstellbarer Energiebarriere (Bulk-
Barrier-Transistor) schematisch dargestellt. Der Transistor besteht wie der an sich bekannte Transistor (Figur 1)
aus einer $n^+$ pn- oder $p^+$ np-Dreischichtenstruktur mit den
drei aneinandergrenzenden Schichten 1, 2 und 3. Die Elektroden an den drei Schichten 1, 2, 3 werden analog zum
Transistor als Emitter (E), Basis (B) und Kollektor (C)
bezeichnet. Im Gegensatz zum bekannten Transistor (Figur
1) ist bei der Erfindung die Basiszone (B), das heißt,
die Schicht 2, jedoch so kurz bzw. so dünn, daß bereits
ohne äußere angelegte Spannungen ihr gesamter Bereich von
freien Ladungsträgern verarmt ist. Die sich dabei ergebende Dicke d der Basiszone 2 ist abhängig von der gewählten Dotierungsdichte $N_B$ in der Basis. Die Raumladungsdich-

te $\varrho$ in der Basis wird in der schematischen Darstellung in Figur 2 als konstant angenommen. Der Bulk-Barrier-Transistor unterscheidet sich von der aus der euorpäischen Patentschrift 0 003 130 bekannten Bulk-Barrier-Diode durch einen Basisanschluß zum Anlegen einer Steuerspannung zwischen Basis und Emitter, mit der der Kollektorstrom beeinflußt werden kann.

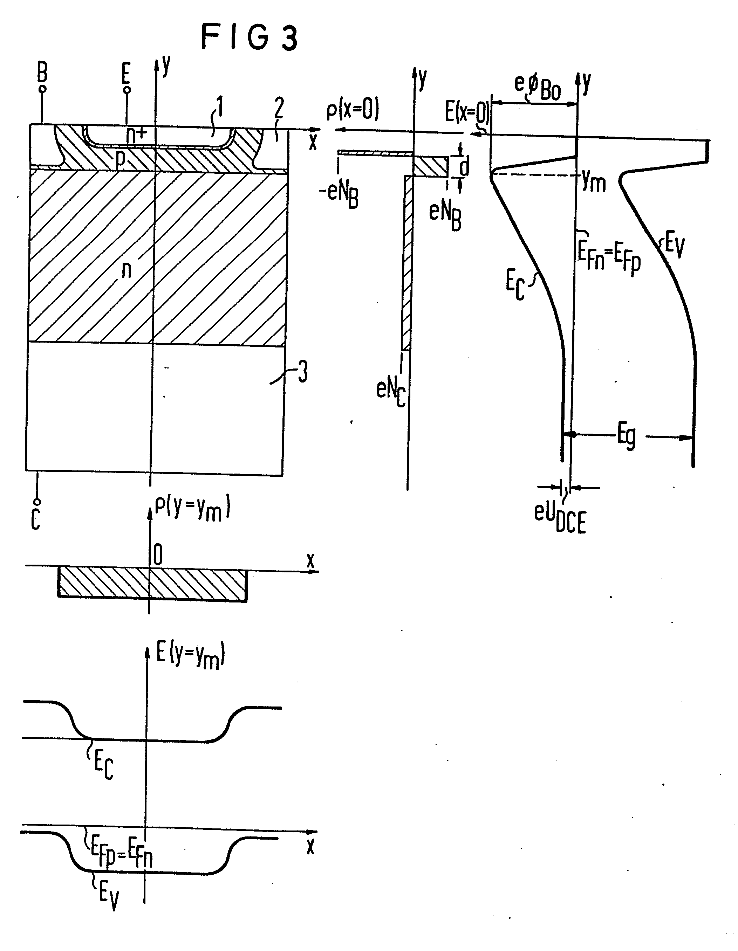

Figur 3 zeigt für eine Ausführungsform des Bulk-Barrier-Transistors die schraffiert gezeichneten Raumladungszonen, den Verlauf der Raumladungsdichte $\varrho$ und den Verlauf der Energien $E_C$ und $E_V$ der Leitungs- und Valenzbandkanten bei thermischem Gleichgewicht. Die Basiszone 2 (p-dotiert) ist zwischen Emitterzone 1 ($n^+$-dotiert) und Kollektorzone 3 (n-dotiert) vollständig von freien Ladungsträgern verarmt. Die Raumladungsdichte $\varrho$ (x = 0) in der Basiszone 2 ist konstant $-eN_B$. Die Höhe der Energiebarriere $e\phi B_o$, die die Elektronen vom Emitter zum Kollektor zu überwinden haben, hängt von der Dicke d und der Dotierungsdichte $N_B$ der Basiszone 2 wie folgt ab:

$$e \phi B_o \simeq e \frac{e N_B}{\varepsilon} \cdot d^2 \qquad (1)$$

Gleichung (1) gilt für $N_E > N_B > N_C$. $N_E$, $N_B$ und $N_C$ sind die Dotierungsdichten im Emitter (E), Basis (B) und Kollektor (C). e ist die Elementarladung und $\varepsilon$ die Elektrizitätskonstante.

Für die Diffusionsspannung $U_{DCE}$ zwischen Kollektor und Emitter gilt:

$$U_{DCE} = (kT/e) \ln (N_E/N_C) \qquad (2)$$

Die thermische Spannung kT/e beträgt bei Zimmertemperatur ca. 25 mV. Im thermischen Gleichgewicht fallen die Quasiferminiveaus von Löchern $E_{Fp}$ und Elektronen $E_{Fn}$ zusammen.

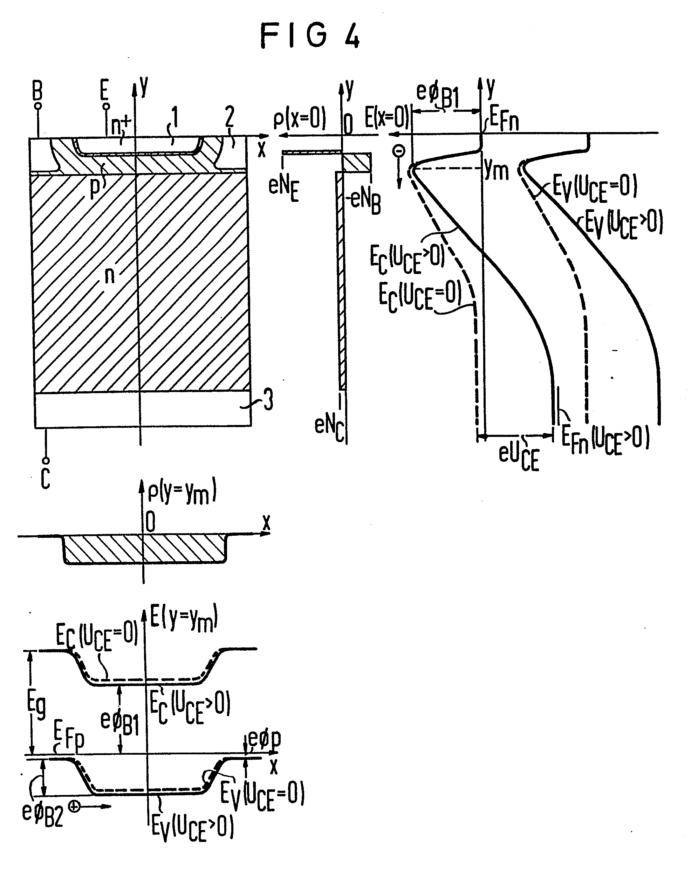

Figur 4 zeigt für die in Figur 3 dargestellte Ausführungsform die schraffiert gezeichneten Raumladungszonen, den

Verlauf der Raumladungsdichte $\rho$ und den Verlauf der Energien $E_C$ und $E_V$ der Leitungs- und Valenzbandkanten bei angelegter Kollektor-Emitter-Spannung $U_{CE}$. Die Höhe der Energiebarriere $e\phi B_1$, die die Elektronen vom Emitter zum Kollektor zu überwinden haben, hängt von der Kollektor-Emitter-Spannung wie folgt ab:

$$e\phi B_1 = e\phi B_0 \left(1 - \sqrt{N_C/N_B}\,\sqrt{1 + (U_{CE} - U_{DCE})/\phi B_0}\right)^2 \quad (3)$$

$e\phi B_0$ ist durch Gleichung (1) und $U_{DCE}$ durch Gleichung (2) definiert. $E_{Fn}$ ist die Energie des Quasiferminiveaus der Elektronen. Löcher, die von der neutralen Basiszone in den Bereich zwischen Emitter und Kollektor gelangen wollen, müssen die im Diagramm $E (y = y_m) = f(x)$ in Figur 4 eingezeichnete Energiebarriere $E\phi_{B_2}$ überwinden. Dafür gilt

$$e\phi B_2 = E_g - e\phi B_1 - e\phi_p \quad (5)$$

$$e\phi_p = kT \cdot \ln(N_V/N_B) \quad (6)$$

In Gleichung (5) sind $E_g$ der Bandabstand des Halbleiters, $e\phi B_1$ die durch Gleichung (3) definierte Energiebarriere und $e\phi_p$ der energetische Abstand des Quasiferminiveaus für Löcher von der Valenzbandkante im neutralen Basisgebiet. $N_V$ ist die äquivalente Zustandsdichte für Löcher in der Basis, $N_B$ die Dotierungsdichte in der Basis und $kT$ die thermische Energie.

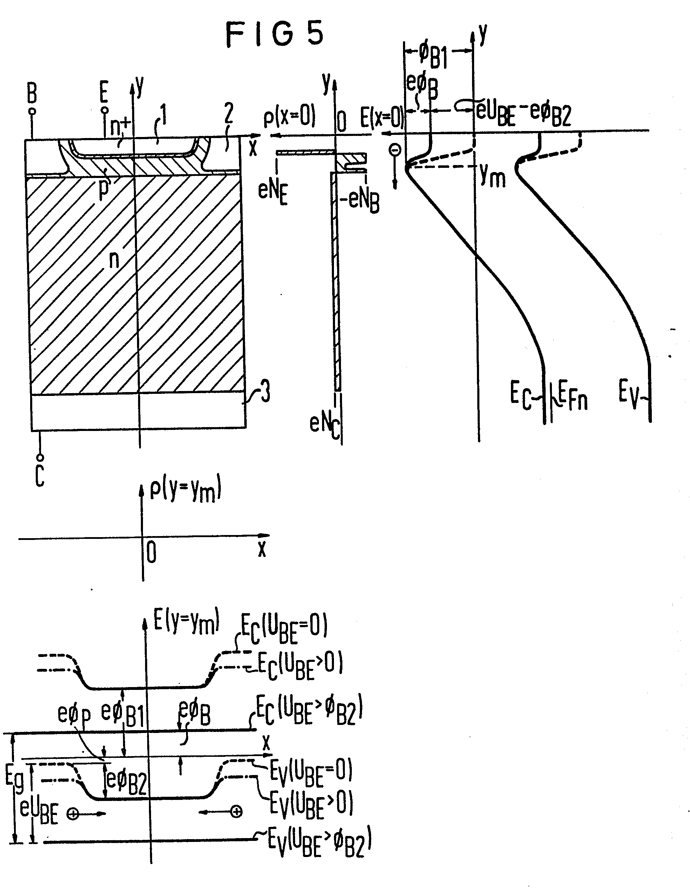

Figur 5 zeigt für die in Figur 3 dargestellte Ausführungsform die schraffiert gezeichneten Raumladungszonen, den Verlauf der Raumladungsdichte $\rho$ und den Verlauf der Energien $E_C$ und $E_V$ der Leitungs- und Valenzbandkanten bei angelegter Kollektor-Emitter-Spannung $U_{CE}$ und Basis-Emitter-Steuerspannung $U_{BE}$. Wie in dem Diagramm $E (y = y_m)$ in Figur 5 gezeigt ist, wird durch die Steuerspannung $U_{BE}$ die Energiebarriere für Löcher von der neutralen Basiszone in den Bereich zwischen Emitter und Kollektor abge-

baut. Durch den Barrierenabbau werden zunehmend Löcher in den Raumladungsbereich zwischen Emitter und Kollektor injiziert. Die positiv geladenen Löcher kompensieren einen Teil der negativen Raumladung in der Basiszone und führen damit zu einer Reduzierung der Höhe der Energiebarriere für Elektronen, die vom Emitter in den Kollektor gelangen wollen. Besonders stark wirkt sich der Effekt dann aus, wenn die Basis-Emitterspannung $U_{BE}$ größer ist als das durch Gleichung (5) definierte und im Diagramm E ($y = y_m$) in Figur 5 eingezeichnete Potential $\phi_{B_x}$. Für $U_{BE} > \phi_{B_x}$ gilt für die im Diagramm E ($x = 0 = f(y)$ in Figur 5 eingezeichnete Energiebarriere für Elektronen vom Emitter zum Kollektor

$$e\phi_B = E_g - e\phi_p - e\,U_{BE} \qquad (7)$$

Eg ist der Bandabstand des Halbleiters, $e\phi_p$ der durch die Gleichung (6) definierte energetische Abstand des Quasiferminiveaus für Löcher von der Valenzbandkante im neutralen Basisgebiet.

Die Berechnung des Kollektorstromes $I_C$ erfolgt entweder mit der thermionischen Emissionstheorie, der Diffusionstheorie oder der thermionischen Diffusionstheorie. Die thermionische Emissionstheorie gilt, wenn sich das elektrische Potential innerhalb der mittleren freien Weglänge der Ladungsträger um mehr als kT/e ändert. Im anderen Fall gilt die Diffusionstheorie und im Übergangsbereich die thermionische Diffusionstheorie. Bei allen Theorien ergibt sich eine exponentielle Abhängigkeit des Stromes I von der Energiebarriere $e\phi$ wie folgt:

$$I = I_0 \exp(-e\phi/kT) \qquad (8)$$

kT ist die thermische Energie.

Der Unterschied der verschiedenen Theorien drückt sich im Sättigungsstrom $I_0$ aus.

Mit den Gleichungen (7) und (8) folgt für den Kollektor-strom $I_c$ bei einer Basis-Emitterspannung von $U_{BE} > \phi B_2$:

$$I_c = I_{c_0} \, exp \left[ -( E_g - e\phi_p )/kT \right] exp \left[ e \cdot U_{BE}/kT \right] \quad (9)$$

in Gleichung (9) ist $I_{Co}$ der Sättigungsstrom, $e\phi_p$ der mit Gleichung (6) definierte energetische Abstand des Quasiferminiveaus $E_{Fp}$ für Löcher von der Valenzbandkante im neutralen Basisgebiet. Eg ist der Bandabstand des Halbleiters und KT die thermische Energie.

Aus Gleichung (9) geht hervor, daß der Kollektorstrom $I_C$ durch die Basis-Emitter-Spannung $U_{BE}$ gesteuert werden kann.

Figur 6 zeigt das mit Gleichung (9) beschriebene Ausgangskennlinienfeld des Bulk-Barrier-Transistors. Mit zunehmender Basis-Emitter-Spannung $U_{BE}$ steigt der Kollektorstrom $I_C$ exponentiell an.

Figur 7 zeigt eine mögliche Ausführungsform des erfindungsgemäßen Bulk-Barrier-Transistors. Die Emitterzone 1 ($n^+$) und die Basiszone 2 (p) können entweder durch Diffusion von Dotierungsatomen oder durch Implantation von Dotie-rungsionen oder durch dotierte Epitaxieabscheidung, zum Beispiel Molekularstrahlepitaxie, oder durch Atomumwandlung infolge von Neutronenbeschuß erzeugt werden. Die Basisanschlüsse 14 ($p^+$) werden entweder durch Diffusion oder durch Ionenimplantation hergestellt. Die ohmschen Kontakte an Emitter 5 (E), Basis 6 (B) und Kollektor 7 (C) bestehen entweder aus einem Halbleiter, einer Halbleiter-Metall-Verbindung, zum Beispiel Metallsilizid, oder einem geeigneten Metall, zum Beispiel Aluminium. Das Halbleitermaterial kann entweder ein Elementhalbleiter wie Germanium oder Silizium oder ein Verbindungshalbleiter, zum Beispiel Galliumarsenid, sein.

Charakteristisch für den Bulk-Barrier-Transistor ist, daß die Schichtdicke der Basiszone 2 (p) so gewählt wird, daß sie bereits ohne angelegte äußere Spannungen in ihren gesamten Bereich zwischen Emitterzone ($n^+$) 1 und Kollektorzone (n) 3 von freien Ladungsträgern verarmt ist.

Die mit dem Bezugszeichen 8 markierten Bereiche zeigen Isolationsgebiete zum Beispiel aus $SiO_2$ an.

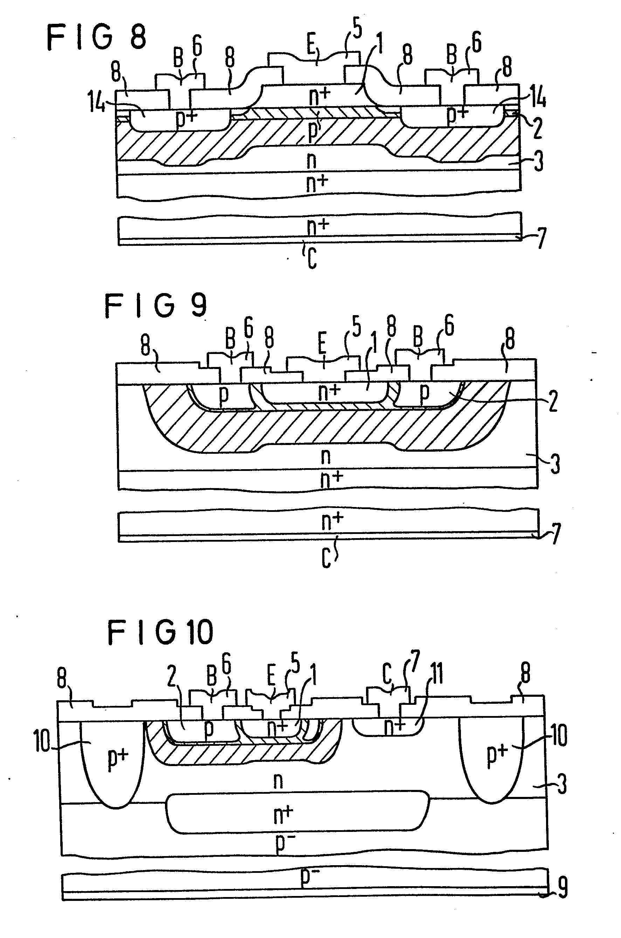

Figur 8 zeigt eine andere Ausführungsform des erfindungsgemäßen Bulk-Barrier-Transistors. Für die Erzeugung der Emitterzone 1, der Basiszone 2 und der Basisanschlüsse 14, für die Herstellung der ohmschen Kontakte 5, 6, 7 an Emitter, Basis und Kollektor, sowie für das Halbleitermaterial gilt das gleiche wie für die Figur 7 gezeigte Ausführungsform. Die laterale Emitterstrukturierung erfolgt zum Beispiel durch Naß- oder Trockenätzung mit geeigneter Ätzmaske.

Auch bei der in Figur 8 gezeigten Ausführungsform ist es erforderlich, daß die Basiszone 2 so dünn ist, daß sie bereits ohne angelegte Spannungen in ihrem gesamten Bereich zwischen der Emitterzone und der Kollektorzone von freien Ladungsträgern verarmt ist.

Figur 9 zeigt eine weitere Ausführungsform des erfindungsgemäßen Bulk-Barrier-Transistors. Sie unterscheidet sich vom bekannten Bipolartransistor, wie er beispielsweise in H. Schrenk "Bipolare Transistoren", Springer-Verlag Berlin (1978), Seite 190, offenbart ist, dadurch, daß die Schichtdicke der Basiszone (p) 2 so gewählt wird, daß bereits ohne angelegte äußere Spannungen ihr gesamter Bereich zwischen der Emitterzone 1 und der Kollektorzone 3 von freien Ladungsträgern verarmt ist. Emitterzone ($n^+$) und Basiszone (p) werden entweder durch Diffusion oder Ionenimplantation von Dotierungsatomen erzeugt. Für das Halbleitermaterial sowie für die Herstellung der ohmschen Kontakte an Emitter, Basis und Kollektor gilt das gleiche wie für die in Figur 7 gezeigte Ausführungsform.

Figur 10 zeigt eine Ausführungsform des erfindungsgemäßen Bulk-Barrier-Transistors für den Einsatz in integrierten Schaltungen, bei der die einzelnen Transistoren durch Dotierzonen ($p^+$) 10 voneinander elektrisch isoliert sind. Diese Ausführungsform unterscheidet sich vom bekannten Bipolartransistor, wie er beispielsweise in einem Aufsatz von Lohstroh in Solid State Devices 1980, Conf. Ser. Nr. 57, Seiten 51 bis 73 offenbart ist dadurch, daß die Schichtdicke der Basiszone (p) 2 so gewählt wird, daß bereits ohne angelegte äußere Spannungen ihr gesamter Bereich zwischen der Emitterzone ($n^+$) 1 und der Kollektorzone (n) 3 von freien Ladungsträgern verarmt ist. Emitterzone, Basiszone und Isolationsdotierung 10 ($p^+$) werden entweder durch Diffusion oder Ionenimplantation von Dotierungsatomen erzeugt. Für das Halbleitermaterial, sowie für die Herstellung der ohmschen Kontakte an Emitter, Basis und Kollektor gilt das gleiche wie für die in Figur 7 gezeigte Ausführungsform. Mit dem Bezugszeichen 9 ist der ohmsche Kontakt am Substrat, mit 11 der $n^+$-dotierte Kollektoranschluß bezeichnet.

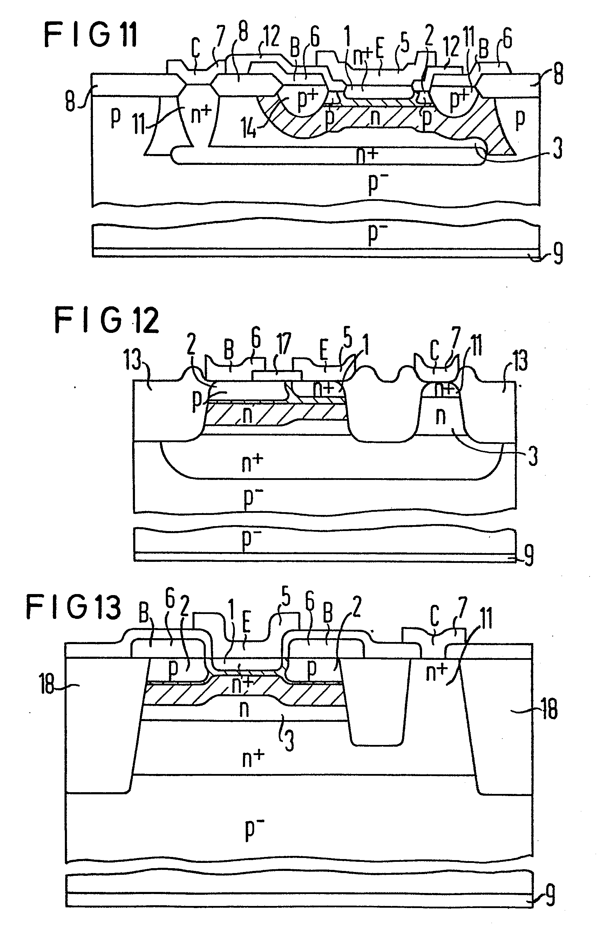

Figur 11 zeigt eine andere Ausführungsform des erfindungsgemäßen Bulk-Barrier-Transistors für den Einsatz in integrierten Schaltungen, bei der die einzelnen Transistoren durch Dotierungszonen ($p^+$) 10 und Isolatorschichten 8 (zum Beispiel $SiO_2$) voneinander elektrisch isoliert sind. Es gelten die gleichen Bezugszeichen wie in Figur 8 und 10. Kollektor 7-, Emitter 5- und Basiskontakt 6 bestehen aus Polysilizium. Mit dem Bezugszeichen 12 sind Isolationsbereiche aus zum Beispiel $SiO_2$ zwischen Emitter/Kollektor und Emitter/Basis angedeutet.

Figur 12 zeigt eine weitere Ausführungsform des erfindungsgemäßen Bulk-Barrier-Transistors für den Einsatz in integrierten Schaltungen, bei der die einzelnen Transistoren durch Isolatorschichten 13 (zum Beispiel $SiO_2$) voneinander elektrisch isoliert sind. Mit 17 ist ein Isolationsbereich zwischen Emitter und Basis bezeichnet, der zum Beispiel aus $SiO_2$ oder Siliziumnitrid bestehen kann. Basiszone (p) 2 und Kollektorzone (n) 3 können entweder durch Diffusion oder Ionenimplantation von Dotierungsatomen oder durch dotierte Epitaxieabscheidung, zum Beispiel Molekularstrahlepitaxie, oder durch Atomumwandlung infolge von Neutronenbeschuß erzeugt werden. Für die Herstellung der Emitterzone ($n^+$) 1 und des Kollektoranschlusses ($n^+$) 11 eignen sich Diffusionen oder Ionenimplantationen. Für das Halbleitermaterial sowie für die Herstellung der ohmschen Kontakte 5, 6, 7 an Emitter, Basis und Kollektor gilt das gleiche wie für die in Figur 7 gezeigte Ausführungsform.

Figur 13 zeigt eine weitere Ausführungsform des erfindungsgemäßen Bulk-Barrier-Transistors für den Einsatz in integrierten Schaltungen, bei der die einzelnen Transistoren durch Grabenisolation, zum Beispiel aus $SiO_2$-Bereichen 18 voneinander elektrisch isoliert sind. Basiszone 2 und Kollektorzone 3 können entweder durch Diffusion oder Ionenimplantation von Dotierstoffatomen erzeugt werden. Die Emitterzone ($n^+$) 1 wird selbstjustierend durch Ionenimplantation und/oder durch Ausdiffusion von Dotierstoffatomen aus den darüberliegenden dotierten Polysilizium (5) hergestellt. Für das Halbleitermaterial eignet sich am besten Silizium. Die ohmschen Kontakte 5, 6 an Emitter und Basis bestehen aus dotiertem Polysilizium. Der ohmsche Kontakt 7 am Kollektor besteht aus dotiertem Polysilizium, aus einem Metallsilizid oder aus einem Metall.

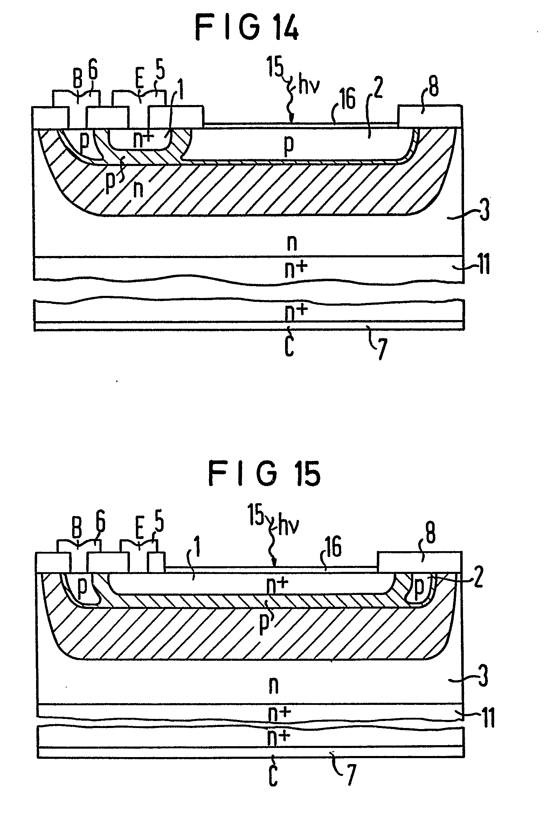

Figur 14 zeigt eine Ausführungsform des erfindungsgemäßen Bulk-Barrier-Transistors für den Einsatz als Fototransistor, bei der das Licht ($h\nu$) 15 in den neutralen Bereich der Basiszone 2 eingestrahlt wird. Diese Ausführungsform unterscheidet sich vom bekannten Fototransistor (Millnes, Semiconductor Devices and Integrated Electronics, Van Nostrand Reinh. Comp. New York (1980), Seiten 772 bis 775) dadurch, daß die Schichtdicke der Basiszone (p) so gewählt wird, daß bereits ohne angelegte äußere Spannungen ihr gesamter Bereich zwischen der Emitterzone ($n^+$) 1 und der Kollektorzone (n) 3 von freien Ladungsträgern verarmt ist. Basiszone 2 und Emitterzone 1 können entweder durch Diffusion oder Ionenimplantation von Dotierstoffatomen erzeugt werden. Die ohmschen Kontakte 5, 6, 7 an Emitter, Basis und Kollektor bestehen aus einem dotierten Halbleiter oder einer Halbleiter-Metallverbindung, zum Beispiel Metallsilizid, oder aus einem Metall wie zum Beispiel Aluminium. Durch das eingestrahlte Licht 15 werden in der Basiszone 2 Elektronen-Loch-Paare generiert. Die Löcher, die in den Bereich der Basis zwischen Emitterzone 1 und Kollektorzone 3 diffundieren, kompensieren einen Teil der negativen Raumladung in der Basis. Dadurch wird die Energiebarriere für Elektronen in der Basiszone 2 abgebaut und der Strom von Emitter in den Kollektor erhöht. Mit dem Bezugszeichen 16 ist eine Antireflexionsschicht bezeichnet.

Figur 15 zeigt eine andere Ausführungsform des erfindungsgemäßen Bulk-Barrier-Transistors für den Einsatz als Fototransistor, bei der das Licht ($h\nu$) 15 in die Emitterzone 1 eingestrahlt wird. Die Schichtdicke der Basiszone (p) 2 wird so gewählt, daß bereits ohne angelegte äußere Spannungen ihr gesamter Bereich zwischen der Emitterzone (1) und der Kollektorzone (3) von freien Ladungsträgern verarmt ist. Basiszone 2 und Emitterzone 1 können entweder durch Diffusion oder Ionenimplantation von Dotierstoffatomen erzeugt werden. Die ohmschen Kontakte 5, 6, 7 an Emitter, Basis und Kollektor bestehen aus einem dotierten Halbleiter oder einer Halbleiter-Metallverbindung zum Beispiel aus Metallsilizid oder aus einem Metall wie zum Beispiel Aluminium. Durch das eingestrahlte Licht 15 werden in der Emitterzone 1 Elektron-Loch-Paare generiert. Die Löcher gelangen in die Potentialmulde der Basiszone 2 und kompensieren einen Teil der Raumladung in der Basiszone 2. Dadurch wird die Energiebarriere für Elektronen in der Basiszone 2 abgebaut, wodurch der Strom vom Emitter zum Kollektor ansteigt.

16 Patentansprüche
15 Figuren

Patentansprüche

1. Transistor mit einstellbarer Energiebarriere und mit ohmschen Kontakten, bestehend aus einer $n^+$ pn- oder $p^+$ np-Dreischichtstruktur (1, 2, 3), bei der die mittlere Schicht (2) (Basis) in ihrer Dicke so dünn ausgebildet ist, daß bereits ohne äußere an die Elektroden angelegte elektrische Spannung bei der gegebenen Dotierung dieser Schicht (2) ihr gesamter Bereich von freien Ladungsträgern verarmt ist, d a d u r c h g e k e n n z e i c h - n e t , daß für die Dotierungsdichten N von Emitter (E)-, Basis (B)- und Kollektorzone (C) gilt: $N_{Emitter} > N_{Basis} > N_{Kollektor}$ und daß die Steuerung des Kollektorstroms über eine angelegte Basis-Emitter-Spannung ($U_{BE}$) erfolgt.

2. Transistor nach Anspruch 1, g e k e n n z e i c h - n e t d u r c h die Dotierungsdichten $N_E$ im Bereich von $10^{17} - 10^{21}$ cm$^{-3}$, $N_B$ im Bereich von $10^{15} - 10^{20}$ cm$^{-3}$ und $N_C$ im Bereich von $< 10^{18}$ cm$^{-3}$.

3. Transistor nach Anspruch 1 und 2, d a d u r c h g e k e n n z e i c h n e t , daß die Dicke der mittleren Schicht (2) (Basis) kleiner als 1000 nm bemessen ist.

4. Transistor nach Anspruch 3, d a d u r c h g e - k e n n z e i c h n e t , daß die Dicke der mittleren Schicht (2) im Bereich von 50 nm bis 200 nm liegt.

5. Transistor nach Anspruch 1 bis 4, d a d u r c h g e k e n n z e i c h n e t , daß die Schichten des Transistors (1, 2, 3) aus dem gleichen Halbleitermaterial bestehen.

6. Transistor nach Anspruch 5, d a d u r c h g e - k e n n z e i c h n e t , daß als Halbleitermaterial Silizium oder Germanium verwendet ist.

7. Transistor nach Anspruch 4, d a d u r c h  g e - k e n n z e i c h n e t , daß als Halbleitermaterial ein Verbindungshalbleiter, vorzugsweise GaAs, verwendet ist.

8. Transistor nach Anspruch 1 bis 4, d a d u r c h  g e - k e n n z e i c h n e t , daß die Schichten des Transistors (1, 2, 3) aus mindestens zwei voneinander verschiedenen Halbleitermaterialien bestehen.

9. Transistor nach Anspruch 1 bis 8, d a d u r c h g e k e n n z e i c h n e t , daß die ohmschen Kontakte an Emitter (1)- Basis (2)- und Kollektorzone (3) aus Metallen, Metallsiliziden oder Polysilizium bestehen.

10. Transistor nach Anspruch 1 bis 9, d a d u r c h g e k e n n z e i c h n e t , daß die Emitterzone (1) und die Basiszone (2) durch Diffusion von Dotierungsatomen oder durch Implantation von Dotierungsionen und/oder durch Molekularstrahlepitaxie erzeugt sind.

11. Verwendung eines Transistors nach einem der Ansprüche 1 bis 10 als Fotodetektor für sichtbare und/oder ultraviolette und/oder infrarote elektromagnetische Strahlung.

12. Verwendung eines Transistors nach einem der Ansprüche 1 bis 10 als Verstärkerelement.

13. Verwendung eines Transistors nach einem der Ansprüche 1 bis 10 als Schaltelement.

14. Verwendung eines Transistors nach einem der Ansprüche 1 bis 10 als Mischer.

15. Verwendung eines Transistors nach einem der Ansprüche 1 bis 10 als Oszillator.

16. Verwendung eines Transistor nach einem der Ansprüche
1 bis 10 als Temperatursensor.

FIG 1

FIG 2

FIG 3

# FIG 4

FIG 5

0106254

4/8

## FIG 6

## FIG 7

FIG 8

FIG 9

FIG 10

FIG 11

FIG 12

FIG 13

## FIG 14

## FIG 15